# EUROPÄISCHE PATENTSCHRIFT

(11) **EP 0 795 905 B1**
(45) Veröffentlichungstag und Bekanntmachung des Hinweises auf die Patenterteilung: **25.08.2004**
(21) Anmeldenummer: 97810047.7
(22) Anmeldetag: 31.01.1997
(51) Int. Cl.: H01L 23/367

(54) **Kühlkörper für Halbleiterbauelemente od. dgl. Einrichtungen**
Heat sink for semi-conductor devices or similar arrangements
Dissipateur de chaleur pour dispositif semi-conducteur ou arrangements similaires

(30) Priorität: 09.02.1996 DE 29602212 U
(43) Veröffentlichungstag der Anmeldung: 17.09.1997
(73) Patentinhaber: Alcan Technology & Management AG, 8212 Neuhausen am Rheinfall (CH)
(72) Erfinder: Bock, Uwe, 78224 Singen (DE)
(74) Vertreter: Hiebsch, Gerhard F., Dipl.-Ing.

(56) Entgegenhaltungen:
- EP-A- 0 483 058
- DE-A- 2 502 472
- DE-A- 3 518 310

## Beschreibung

Die Erfindung betrifft einen Kühlkörper für Halbleiterbauelemente mit in Abstand zueinander von einem Gehäusesockel aufragenden Kühlrippen, die jeweils mit einem Kupplungssockel in einer in die Oberfläche des Gehäusesockels eingebrachten Einsatznut klemmend gehalten sind, nach dem Oberbegriff des Anspruches 1.

Kühlrippen dieser Art sind der DE 35 18 310 A1 zu entnehmen; nach deren Lehre werden stranggepreßte Vollprofile mit seitlichen Ausformungen als Kühlrippen in die Einsatznuten der Grundplatte formschlüssig eingesetzt. Die Nutwände der Einsatznut werden nach dem Einbringen der Kühlrippe durch ein keilartiges Werkzeug verformt, das dazu in eine Hilfsnut V-förmigen Querschnitts eingesetzt wird und teilweise den Werkstoff des Gehäusesockels in Parallelnuten drückt, die im Kupplungssockel der Kühlrippe verlaufen.

Die DE 25 02 472 A1 schildert flache Kühlrippen, die parallel zueinander an einer -- oder zwischen zwei -- quer zu ihnen gerichteten, mit Aufnahmenuten für die eingeschobenen Enden der Kühlrippen versehenen Grundplatte verlaufen. Die Kühlrippen sind -- bevorzugt beidseits -- mit dicht beieinander liegenden Riefen oder mit noppenartigen Vorsprüngen versehen und werden unter Druck in die Aufnahmenuten eingepresst, um eine Kaltverschweißung mit den Nutenwänden zu erhalten. Zusätzlich können solche Parallelrillen auch in die Nutwände eingebracht sein, um den zum Einpressen nötigen Druck zu vermindern.

Als Hohlprofile ausgebildete Kühlrippen mit einem gegenüber der Breite des Hohlprofils engeren Kupplungssockel bietet die EP 0 483 058 A1 der Anmelderin an. Die Kupplungssockel sind beidseits mit parallel zueinander verlaufenden Einformrinnen ausgerüstet.

In Kenntnis dieses Standes der Technik hat sich der Erfinder die Aufgabe gestellt, bei einer einfachen Ausführung des eingangs erwähnten Kühlkörpers Herstellungsaufwand zu vermindern und den Verbund Gehäusesockel/Kühlrippe zu verbessern.

Zur Lösung dieser Aufgabe führt die Lehre des unabhängigen Anspruches; die Unteransprüche geben günstige Weiterbildungen an.

Erfindungsgemäß eben ausgebildet sowie gegenüberliegenden Nutenwände ist der Werkstoff der Kühlrippen weicher ist als der Werkstoff des Gehäusesockels, und die Verkstoffe jeweils aus einer Aluminiumlegierung, zudem sind die Flankenflächen des Kupplungssockels eben ausgebildet sowie die diesen gegenüberliegenden Nutenwände mit querschnittlich wellenartigen, parallel zum Nutentiefsten verlaufenden Ausformungen versehen die von den Ausformungen begrenzten Längsnuten der Nutenwand nehmen Werkstoff des Kupplungssockels, der durch einem Verformungsvorgang in den Werkstoff der Kühlrippen eingedrückt ist. Als günstig hat es sich dazu erwiesen.

Durch den Verformungsvorgang werden die Nutenwände also in den Werkstoff der Kühlrippe eingedrückt, wodurch diese dann unverrückbar formschlüssig festliegt. Bei diesem Vorgang bewegen sich die Ausformungen aktiv auf jene glatten Flankenflächen zu, was die Bindungswirkung -- gegenüber dem Stande der Technik gesehen -- erheblich verbessert.

Eine derartige Kühlrippe zeichnet sich auch dadurch aus, daß der Kupplungssockel unter Bildung von Schrägschultern schmaler ist als die Kühlrippenbreite, so daß sich die Kühlrippe nach dem Einbringen des Kupplungssockels von der Einsatznut weg aufwärts verbreitert. die Kühlrippe in an sich bekannte Weise als Hohlprofil in gestalten.

Weitere Vorteile, Merkmale und Einzelheiten der Erfindung ergeben sich aus der nachfolgenden Beschreibung eines bevorzugten Ausführungsbeispiels sowie anhand der Zeichnung; diese zeigt in:
- Fig. 1:: die Frontansicht eines Kühlkörpers mit Kühlrippen auf einem Gehäusesockel;
- Fig. 2:: eine gegenüber Fig. 1 vergrößerte Darstellung einer Kühlrippe;
- Fig. 3:: einen vergrößerten Ausschnitt des Gehäusesockels mit zugeordneter Kühlrippe.

Ein Kühlkörper 10 für Halbleiterbauelemente weist ein in der Zeichnung aus Gründen der Übersichtlichkeit nicht weiter dargestelltes Gehäuse mit einem Gehäusesockel 12 der Breite a von hier 300 mm und einer Dicke b von beispielsweise 30 mm auf.

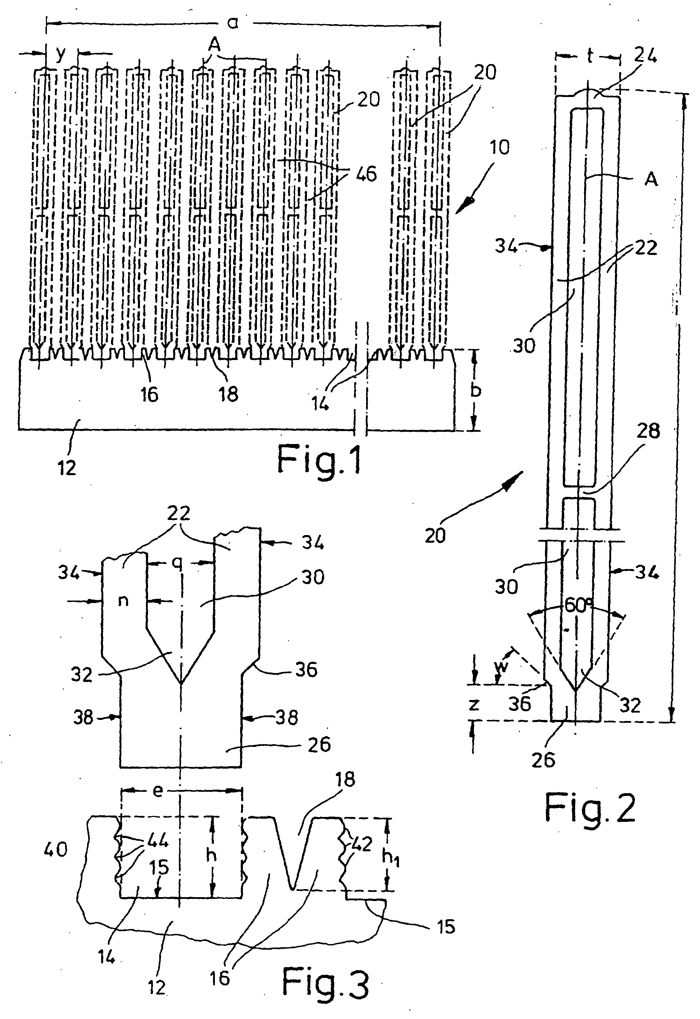

In den Gehäusesockel 12 sind -- in Fig. 1,3 sich aufwärts öffnende -- Einsatznuten 14 etwa rechteckigen Querschnitts einer Breite e von etwa 6 mm und eine Tiefe h von etwa 4 mm eingeformt, die durch Bodenrippen 16 voneinander getrennt sind; in jede dieser Bodenrippen 16 ist eine querschnittlich V-förmige Hilfsnut 18 der Tiefe h₁ eingeformt; diese ist kürzer als die Tiefe h der Einsatznut 14.

In den Einsatznuten 14 sind zueinander parallel verlaufende Kühlrippen 20 festgelegt. Gehäusesockel 12 und Kühlrippen 20 werden getrennt auf dem Wege des Strangpressens aus Aluminiumlegierungen hergestellt und anschließend zusammengefügt.

Die Kühlrippe 20 ist als Hohlprofil der Länge i von 100 mm ausgebildet; zwei parallele Seitenwände 22 der Dicke n von hier 1,8 mm sind an ihren Enden einerseits durch eine Kopfwand 24 und anderseits durch einen Kupplungssockel 26, zudem durch eine etwa in ihrer Höhenmitte verlaufende Querwand 28 untereinander verbunden; in der Kühlrippe 20 entstehen so zwei Hohlräume 30 etwa gleicher Höhe und einer lichten Weite q von etwa 4 mm.

Der untere Hohlraum 30 endet zum Kupplungssockel 26 hin mit einem sich zur Mittelachse A hin verjüngenden Bereich 32. Da der Kupplungssockel 26 der Kühlrippe 20 schmaler ist als die Kühlrippenbreite t von etwa 7 mm, gehen die Außenflächen 34 der Seitenwände 22 an jenem Bereich 32 in Schrägschultern 36 eines Neigungswinkels w von 45° über, diese dann in glatte Flankenflächen 38 der Höhe z von 4,5 mm.

Der Kupplungssockel 26 wird in die Einsatznut 14 eingeschoben, bis er dem Nutentiefsten 15 aufsitzt. Zur Lagesicherung sind -- wie Fig. 3 zeigt -- die Nutenwände 40 mit querschnittlich sägezahnartigen Längsausformungen 42 versehen. Nach dem Einsetzen des Kupplungssockels 26 in die Einsatznut 14 wird in die benachbarte Hilfsnut 18 ein keilförmiges Werkzeug eingesetzt, dessen querschnittliche Keilform breiter ist als die der Hilfsnut 18. Durch Aufweitung der Hilfsnut 18 wird der Werkstoff der Bodenrippe 16 zur Einsatznut 14 hin gedrückt, und dabei werden jene Längsausformungen oder Längsrippen 42 aktiv in den Werkstoff des Kupplungssockels 26 eingetrieben; dabei schiebt sich der Werkstoff in die zwischen den Längsausformungen 42 verlaufenden Wellentäler der Längsnuten 44 der beiden Nutenwände 40. Der Kupplungssockel 26 sitzt dann formschlüssig fest im Gehäusesockel 12.

Die Abstände y der Mittelachsen A der Kühlrippen 20 messen etwas mehr als 10 mm, so daß die Kühlrippenzwischenräume 46 etwa der Hohlraumweite q entsprechen.

## Patentansprüche

1. Kühlkörper (10) für Halbleiterbauelemente mit in Abstand zueinander von einem Gehäusesockel (12) aufragenden Kühlrippen (20), die jeweils mit einem Kupplungssockel (26) in einer in die Oberfläche des Gehäusesockels (12) eingebrachten Einsatznut (14) klemmend gehalten sind, wobei der Gehäusesockel (12) und die Kühlrippen aus Leichtmetall durch strangpressen gefertigt sind,
**dadurch gekennzeichnet**,
und die Verkstoffe jeweils aus einer Aluminiumlegierung bestehen, daß die Flankenflächen (38) des Kupplungssockels (26) eben ausgebildet sowie die diesen gegenüberliegenden Nutenwände (40) mit querschnittlich wellenartigen, parallel zum Nutentiefsten (15) verlaufenden Ausformungen (42) versehen sind, wobei die von den Ausformungen (34) begrenzten Längsnuten (44) der Nutenwand (40) Werkstoff des Kupplungssockels (28) aufnehmen, der durch einen Verformungsvorgang in den werkstoff der kuhlrippen eingedrückt ist.

2. Kühlkörper nach Anspruch 1, **dadurch gekennzeichnet, daß** seine Kühlrippe (20) als Hohlprofil ausgebildet ist sowie die Weite (q) des Kühlrippenhohlraumes (30) etwa dem lichten Abstand zweier Kühlrippen (20) entspricht.

3. Kühlkörper nach Anspruch 1 oder 2, **dadurch gekennzeichnet, daß** der Kupplungssockel (26) unter Bildung von Schrägschultern (36) schmaler ist als die Kühlrippenbreite (t).

## Claims

1. Heat sink (10) for semiconductor devices, comprising cooling fins (20) projecting from a housing base (12) at a distance from one another and each clamped in an insertion slot (14) introduced into the surface of the housing base (12) by means of a coupling base (26), the housing base (12) and the cooling fins being produced from light metal by extrusion, **characterised in that** the material of the cooling fins (20) is softer than the material of the housing base (12) and the materials each consist of an aluminium alloy, and that the flank surfaces (38) of the coupling base (26) are flat and the slot walls (40) situated opposite are provided with projections (42) with a wavy cross section extending parallel to the bottom (15) of the slot, the longitudinal slots (44) in the slot wall (40) delimited by the projections (34) receiving material of the coupling base (28) which is pressed into the material of the cooling fins by a deformation process.

2. Heat sink according to claim 1, **characterised in that** its cooling fin (20) is in the form of a hollow section and the width (q) of the hollow space (30) of the cooling fin corresponds approximately to the distance between two cooling fins (20).

3. Heat sink according to claim 1 or claim 2, **characterised in that** the coupling base (26) is narrower than the width (t) of the cooling fin by the formation of stepped shoulders (36).

## Revendications

1. Corps dissipateur de chaleur (10) pour composants à semi-conducteurs, comportant des ailettes de refroidissement (20) qui font saillie d'une semelle de carter (12) en étant espacées les unes des autres, et qui sont maintenues par serrage, chacune avec une embase de couplage (26), dans une rainure d'insertion (14) formée dans la surface de la semelle de carter (12), la semelle de carter (12) et les ailettes de refroidissement étant fabriquées en un alliage léger par filage ou extrusion,
**caractérisé en ce que** le matériau des ailettes de refroidissement (20) est plus mou que le matériau de la semelle de carter (12), et les matériaux sont constitués chacun par un alliage d'aluminium, **en ce que** les surfaces de flanc (38) de l'embase de couplage (26) sont d'une configuration plane, et les parois de rainure (40) qui sont opposées à ces surfaces de flanc sont pourvues de profils de formage (42) de forme ondulée en section transversale et s'étendant parallèlement au fond (15) de la rainure, les cannelures longitudinales (44) de la paroi de rainure (40), délimitées par les profils de formage (34), recevant du matériau de l'embase de couplage (26), qui est pressé par une opération de déformation, dans le matériau des ailettes de refroidissement.

2. Corps dissipateur de chaleur selon la revendication 1, **caractérisé en ce que** son ailette de refroidissement (20) est réalisée sous forme de profilé creux, et la largeur (q) de la cavité (30) de l'ailette de refroidissement correspond environ à la distance d'espacement libre entre deux ailettes de refroidissement (20).

3. Corps dissipateur de chaleur selon la revendication 1 ou 2, **caractérisé en ce que** l'embase de couplage (26) est plus étroite que la largeur (t) de l'ailette de refroidissement, en formant des épaulements obliques (36).
